(19) Europäisches Patentamt
European Patent Office
Office européen des brevets

(11) Publication number: 0 219 928 B1

(12) **EUROPEAN PATENT SPECIFICATION**

(45) Date of publication of patent specification: **29.04.92** (51) Int. Cl.[5]: **C09D 163/00**, C08L 63/00

(21) Application number: **86305599.2**

(22) Date of filing: **22.07.86**

(54) **Epoxy fluorocarbon coating composition and process to make same.**

(30) Priority: **19.09.85 US 777890**
**25.04.86 US 856625**

(43) Date of publication of application:
**29.04.87 Bulletin 87/18**

(45) Publication of the grant of the patent:
**29.04.92 Bulletin 92/18**

(84) Designated Contracting States:
**DE FR GB**

(56) References cited:
**DE-A- 1 519 010** **DE-A- 2 122 408**
**DE-A- 2 264 132** **FR-A- 2 396 785**
**US-A- 2 777 783** **US-A- 3 023 189**

(73) Proprietor: **THE STANDARD OIL COMPANY**
**200 Public Square, 36-F-3454**
**Cleveland Ohio 44114(US)**

(72) Inventor: **Giordano, Paul J.**
**5595 Hummelfine Drive**
**Hudson Ohio(US)**
Inventor: **Smierciak, Richard C.**
**9285 June Drive**
**Streetsboro Ohio(US)**

(74) Representative: **Smith, Sydney et al**
**Elkington and Fife Prospect House 8 Pembroke Road**
**Sevenoaks, Kent TN13 1XR(GB)**

**EP 0 219 928 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention is directed generally to epoxy fluoropolymer compositions for use as protective surface coatings on various substrates such as metal, wood, plastic, paper and the like. This invention relates to novel 100 percent solids epoxy fluoropolymer coating compositions. In another aspect, the invention relates to novel coating compositions and the process for producing the coating compositions which have excellent corrosion resistance and good adhesion as well as good release properties and hydrophobicity.

There is demand in the industry for protective coatings that will withstand the effects of a variety of severe environmental conditions. Many varieties of coating compositions are currently available that are based on various polymeric materials.

For example, DE-A-1,519,010 discloses a fluid dispersion containing mostly solids which comprise a waxlike fluorocarbon polymer and a thermosettable resin. The fluorocarbon polymer may be in the form of particles having a size of 0.5-10 µm. After application to a substrate the coating is cured by heating to produce a low-friction material.

DE-A-2,264,132 describes a composition comprising a thermosetting resin in which PTFE powder of particle size 5 µm or less is uniformly distributed. After application to a backing substrate the composition is heat cured to provide a bearing material.

DE-A-2,122,408 discloses an acid resistant coating comprising known acid resistant compounds, such as epoxy resins, and particulate polyamides or optionally fluorinated or chlorinated polyolefins, such as PTFE, of particle size 3-80 µm, as pigment.

FR-A-2,396,785 discloses a coating composition comprising an epoxy resin, and a fluorocarbon polymer of unspecified particle size.

Fluorocarbon polymers are generally thermoplastic with, however, a high melting point thus there are significant economic and technical barriers that must be overcome when using them. However, polytetrafluoroethylene is not thermoplastic and therefore must be fabricated. Generally, in the fabrication process the resin is compacted to preform and then is sintered at temperatures above 371 °C (700 degrees F). As such, using polytetrafluoroethylene is energy intensive and only simple shapes can be realized. Fluoropolymer coating compositions exhibit nonstick properties and adhesion to metal at temperatures around 371 °C (700 degrees F). In accordance with this invention, it has been discovered that fluorocarbon polymers can be processed at ambient or relatively low temperatures.

Most coating systems used today are solvent based or water based. Solvent based coating are disadvantageous in that large amounts of volatile organic solvents are present. These solvents may be costly and hazardous. The solvents must be removed from the final coatings which required considerable thermal energy. Further, if hazardous, the solvents must be recovered or incinerated as they may not be exhausted into the environment. Water based coatings are disadvantageous in that they are not continuous and have been found to contain more pinholes and voids than the solvent based coatings.

As a result, the search for an essentially solvent-free coating process has led to the use of solventless systems. The advantages of a solventless coating system includes the minimization of surface defects due to the absence of solvents and excellent heat and chemical resistance.

It is an object of this invention to provide an epoxy fluoropolymer coating composition in a 100 percent solids, solvent free system to avoid use of cyclable solvents. It is another object of this invention to produce a corrosion resistant coating that is cured at ambient or relatively low temperatures. It is another object of this invention to form a coating composition with the excellent adhesion, good wetting, good cohesion, good hydrophobicity, excellent chemical resistance and good release properties. It is another object of this invention to produce a coating that is resistant to a variety of aggressive environmental conditions.

These and other objects, together with the advantages over known methods shall become apparent from the specifications which follows and are accomplished by the invention as hereinafter described and claimed.

### Summary of the Invention

We have found that a dispersion system of a fluorocarbon polymer in an epoxy resin results in a multifunctional coating system with improved properties. The present invention includes a solventless coating system based on the multi-functional epoxy resin which serves as a resinous vehicle prior to curing and as a matrix material after curing for the fluorocarbon polymer.

This invention relates to coating compositions comprising epoxy resins and fluorocarbon polymers, in particular polytetrafluoroethylene (PTFE), wherein the weight percent of the fluorocarbon polymer is 5 to 24 percent of the total weight of the coating composition and wherein the particle size or the fluorocarbon polymer is less than 500 µm, preferably less than or equal to 150 µm.

The invention further includes a process to produce said coating compositions comprising:

1. forming a dispersion of powdered fluorocarbon polymer in an epoxy resin,
2. adding a curing agent to the dispersion to form a mixture,
3. applying the mixture to a substrate to form a coating, and
4. curing the coating from room temperature to 150 degrees C.

The epoxy fluorocarbon polymer coating compositions of this invention can be used for industrial corrosion protection of substrates where coating properties such as hydrophobicity, good release properties, adhesion and corrosion resistance are important. Major uses for the coatings are in the chemical processing industry for reactors, stirrers, pipes and tankers. Further, the coating compositions may also be used in other fields such as anti-biofouling, anti-icing, electrical insulation and the like.

## Detailed Description of the Invention

The coating compositions of the instant invention are intimate, uniform dispersions of a fluorocarbon polymer in an epoxy resin, which is in the presence of a curing agent.

The coating compositions of the present invention contain an epoxy resin. Epoxy resins are characterized by the presence of a three-membered cyclic ether group commonly referred to as an epoxy group which is represented as follows:

I

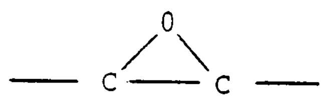

There are two commonly used classes of epoxy resins, diglycidyl ethers of bisphenol A and Novolak epoxy resins. Molecular weight and epoxide equivalent are controlled by varying the reactant ratios. The epoxy resin functions as a dispersing resinous vehicle and matrix for the fluorocarbon polymer. The coating compositions of the present invention are classified as 100 percent solids because they contain essentially no volatile solvents. The fluorocarbon polymer is uniformly dispersed in the epoxy resin resulting in a network of fluoropolymer which is homogeneously dispersed throughout the composite. However, minor amounts of solvents may optionally be used that may be volatile, which does not defeat the object of this invention, to provide a substantially 100 percent solid coating composition.

These epoxy resins can be employed in the coating composition either alone or in combination. The coatings compositions of the present invention generally contain, in percent of the total weight, from 95 percent to 70 percent and preferably from 90 percent to 75 percent of the epoxy resin.

The conventional epoxy resins are diglycidyl ethers of bisphenol A derived from bisphenol A (4,4-isopropylidenediphenol) and epichlorohydrin. The reaction product is believed to have the form of a polyglycidyl ether of bisphenol A (the glycidyl group being more formally referred to as the 2,3-epoxypropyl group) and thus may be thought of as a polyether derived from the diphenol and glycidyl (2,3-epoxy-1-propanol). The structure usually assigned to the resinous product is

(II)

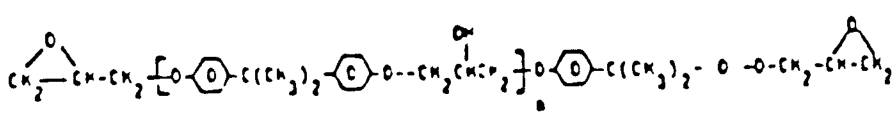

A viscous liquid epoxy resin, average molecular weight about 380, is obtained by reacting the epichlorohydrin in high molecular proportion relative to the bisphenol A, the reaction product containing well over 85 mole percent of the monomeric diglycidyl ether of bisphenol A (represented in formula II, where n = 0), which may be named 2,2-bis(p-(2,3-epoxypropoxy)phenyl)propane, and smaller proportions of units in which n is an integer equal to 1, 2, 3, etc. This product exemplifies epoxide monomers and prepolymers, having a moderate molecular weight, preferably of the order of 1,000 or less, which may be cross-linked or other wise polymerized in accordance with the invention. Solid diglycidyl ethers of bisphenol A are also

useful epoxy resins for the instant invention. The structure is the same as above, in formula II, except the average value of n ranges from 1 to 20. High molecular weight diglycidyl ethers of bisphenol A are also useful for the instant invention. The molecular weight of the product is a function of the ratio of epichlorohydrin-bisphenol A. The average value of n ranges from 1 to 20 and as the n value becomes greater, the molecular weight of the resin increases.

The Novolak Epoxy resins are obtained by the known reaction of epichlorohydrin with a novolak resin. First, a phenol-formaldehyde type resin is obtained primarily by the use of acid catalysts and an excess of phenol. The Epoxy Phenol-Novolak Resins are then prepared from the phenol-formaldehyde condensation products with subsequent epoxidation, utilizing epichlorohydrin. The structure usually assigned this resinous structure is

(III)

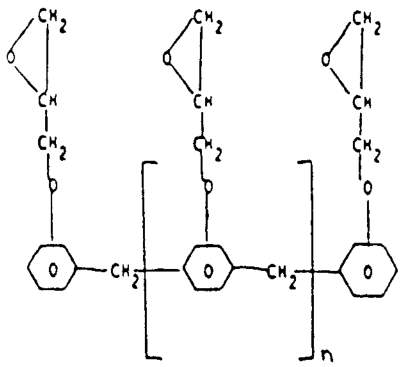

The Epoxy Novolak resin can range from a high viscosity liquid, (an example of which formula III, where n averages about 0.2) to a solid, (where the value of n in formula III is greater than 3).

Many other epoxide materials are available in polymerizeable monomeric or prepolymeric forms. Typical epoxide or polyepoxide materials include but are not limited to cyclohexene oxides, epoxidized cycloalkenes, glycidyl esters of acrylic acid, glycidyl alkyl ethers, glycidyl aryl ethers, esters of epoxidized cyclic acids, halogenated epoxides, styrene oxide, bisphenol F epoxides and the like. The cyclohexene oxides and their derivatives and homologues useful as epoxide materials include but are not limited to cyclohexene oxide, 1,2-epoxycyclohexene, vinylcyclohexene dioxide, more specifically named 3-(epoxyethyl) -7- oxabicyclo (4.1.0) heptane, and 1,2-epoxy-4-(epoxyethyl)cyclohexane. Most preferred is cyclohexene oxide.

The epoxidized cycloalkenes and their derivatives and homologues useful as epoxide materials include but are not limited to the derivatives of ethylene oxide, propylene oxide, trimethylene oxide, 3,3-bis-(chloromethyl)-oxetane, tetrahydrofuran, dicyclopentadiene dioxide, 1,3,5-trioxane, 2,3 epoxybutane, polycyclic diepoxide and 3,4-8,9-diepoxy tricyclo-[5.2.1.$0^{2,4}$]-decane. Most preferred is polycyclic diepoxide.

The glycidyl esters of acrylic acid and their derivatives and homologues include but are not limited to the glycidyl derivatives of methacrylic acid, acrylonitrile, crotonic acid, allylglycidyl ether, 1-allyloxyl-2,3-epoxypropane, glycidyl phenyl ether and 1,2-epoxy-3-phenoxypropane. Most preferred are epoxidized methacrylic acid and acrylonitrile.

The glycidyl alkylethers and their derivatives and homologues include but are not limited to glycidyl octyl ether, dicyl glycidyl ether, dodecyl glycidyl ether and glycidyl tetradecyl ether. Most preferred is glycidyl octyl ether.

The glycidyl aryl ethers and their derivatives and homologues include but are not limited to benzyl glycidyl ether, methyl benzyl glycidyl ether, dimethyl benzyl glycidyl ether, ethyl glycidyl ether. Most preferred is benzyl glycidyl ether.

Esters of epoxidized cyclic alcohols or of epoxidized cycloalkanecarboxylic acids or of both and their derivatives and homologues include but are not limited to esters of epoxidized cyclohexanemethanol and epoxidized cyclohexane-caboxylic acid such as diepoxide (3,4-epoxy-cyclohexyl)methyl 3,4-epoxycyclohexane-carboxylate, esters of a substituted (epoxycycloalkyl) methanol and a dibasic acid such as bis(3,4-epoxy-6-methylcyclohexyl)-methyl) adipate. Diepoxide monomeric materials may be obtained conveniently as bis(epoxyalkyl) ethers of glycols, an example being the diglycidyl ether of 1,4-butanediol, that is, 1,4-bis-(2,3-epoxypropoxy)butane. We have found this diepoxide is related to the diglycidyl ether of bisphenol A, that is 2,2-bis-[p-(2,3-epoxypropoxy)-phenyl] propane.

Reactive diluents and their derivatives and homologues likewise may be used such as 1,2 epoxy dodecane and the like.

The second component of the coating compositions of the present invention is a fluorocarbon polymer. The fluorocarbon polymers according to this invention are not fused or sintered at 371 °C (700 degrees F) but rather the epoxy fluorocarbon compositions are cured at low temperatures, thus retaining good structural properties of hardness and durability. Further, when processed according to the invention, the fluorocarbon polymers do not need reinforcing agents to have good structural properties. The fluorocarbon polymers used are those of hydrocarbon monomers that are perfluorinated.

These fluorocarbon polymers can be employed in the coating composition either alone or in combination. The fluorocarbon polymers used are in powder or granular form. The coating compositions of the present invention generally contain, in percent of total weight, from 5 percent to 24 percent, preferably from 10 percent to 20 percent of powdered fluorocarbon polymers. The fluorocarbon polymers have a particle size less than 500 µm preferably less than or equal to 150 µm.

Typical fluorocarbon polymers include but are not limited to homologues and derivatives of polytetrafluoroethylene, Teflon FEP-a fluorinated ethylene propylene which is a copolymer of tetrafluoroethylene and hexafluoropropylene, Teflon® TFE-tetrafluoroethylene, Teflon® PFA-perfluoroalkoxy resin, Tefzel®-modified copolymer of ethylene and tetrafluoroethylene and the like. Most preferred is polytetrafluoroethylene.

To effect crosslinking of the epoxy resin, the epoxy fluorocarbon mixture is cured by known epoxy resin curing methods. Epoxy resins may be cured both catalytically and stoichiometrically. The epoxy fluorocarbon mixture of the instant invention is cured at 25 degrees C to 150 degrees C and most preferably from 85 degrees C to 100 degrees C. The curing time is dependent on the temperature employed and the kinetics of the reaction to form the coating composition of the instant invention.

Catalytic curing agents are a group of compounds which promote epoxy reactions without being consumed in the process. The catalytic curing agents and the cure of the resin using these agents are generally well known in the art. The amount of catalyst used is 1 to 10 weight percent. This type of catalyst is activated by heat. A heating condition of 80 degrees C is generally used. The upper limit of the heating temperature and the length of time of heating is dependent upon various factors such as the thermal deterioration point and decomposition point of the films and also by heat desirability of the object to be cured. The epoxy fluorocarbon mixture in the presence of the catalytic curing agents is indefinitely stable at room temperature so that the pot life of the system is extremely long. Acidic catalytic curing agents and include but are not limited to carboxylic acids, anhydrides, dibasic organic acids, phenols, Lewis acids, amine aducts, tertiary amines and others. Common catalytic curing agents include but are not limited to benzyldimethylamine, boron trifluoride monoethylamine, formic acid, benzoic acid, formic anhydride, acetic anhydride, oxalic acid, malonic acid, succinic acid, ortho-, meta-, para-cresol and the like.

Stoichiometric curing agents are a group of compounds in which the curing agents are consumed in the cure process. The stoichiometric curing agents and the cure of the resin using these agents are generally well known in the art. The rate of the reaction depends upon the chemistry of the stoichiometric curing agent and the epoxy resin.

Tertiary amines and similar compounds can be used in conjunction with basic compounds to accelerate polymerization of the epoxy materials. The basic stoichiometric curing agents employed include but are not limited to Lewis bases, inorganic bases, primary and secondary amines, amides and others. Examples of suitable stoichiometric curing agents are polysulfides, in particular, mercapto terminated polyoxyethylene; aliphatic amines, in particular, cyclohexyl amine; polyamines, in particular, triethylene tetramine; amidoamines, in particular, the reaction product of ethylene diamine with linoleic acid dimer; aromatic amines, in particular, aniline; anhydrides, in particular, proprionic anhydride; melamine-formaldehyde; urea-formaldehyde; phenol-formaldehydes, in particular, t-butyl phenol-formaldehyde and the like.

Another class of curing agents that may be employed are photoinitiated curing agents. The photoinitiator curing agents and the cure thereof are generally well known in the art. Examples of suitable photoinitiator curing agents include benzophenone, dye sensitizers, triaryl sulfonium salts, benzoin ethers, substituted acetophone, Michler's ketone, benzil and the like. The coating composition is cured by radiation in the range of ultraviolet to visible light. The light source emits wavelengths in the spectrum from $10^4$ nm (1,000 Angstroms) to 6 x $10^4$ nm (6,000 Angstroms). The systems used to generate radiation for the photoinitiated cure can be any known in the art such as low pressure, medium pressure, high pressure or super high pressure mercury lamps; mercury, carbon and plasma arc lamps; xenon lamps; UV light emitting diodes; UV emitting lasers and the like. The coating mixture can also be cured using an electron beam apparatus. Further, the coating mixture can be cured by tungsten lamps, sunlight and the like.

The novel epoxy fluoropolymer coating compositions can optionally include but do not require the addition of plasticizers; silica; glass fiber; cloth; beads; powder; flake; graphite; silicon carbide; boron; metal rod; metal flake; metal oxides; natural fibers such as asbestos, wood and textiles; biologically active

chemicals such as organotin compounds; alumina; boron nitride; plaster and portland cement. The coating compositions of the instant invention have improved results whether or not these components are employed.

It will be readily apparent to those skilled in the art that the coating compositions of the instant invention may be modified by the addition of plasticizers, stabilizers, pigments, dispersants, defoamers, surfactants, extenders, fillers, reinforcing agents and other film formers. The coating compositions of the instant invention may also optionally contain various flattening agents, surface active agents, thixotropic agents, UV light absorbers, flow control agents, viscosity agents, antioxidant agents and dyes. All these additives and the use thereof are well known in the art and do not require extensive discussion, it being understood that any compound possessing the ability to function in such a manner, i.e., as a flattening agent, surface active agent, UV light absorber and the like, can be used so long as they do not deleteriously affect the curing of the coating composition and do not adversely affect the characteristics of the coating. However, these components are not required.

It will be appreciated therefore that the epoxy resins, fluorocarbon polymers, curing agents and any other modifiers should be chemically compatible with each other.

In the practice of this invention, the coating composition precursor is first compounded by adding together the epoxy resins and the fluorocarbon polymers to form generally an intimate, uniform dispersion. To this dispersion is added the curing agents, with stirring to form a mixture. Optionally, at any step in the process prior to the cure, any of the aforementioned additives may be stirred into the mixture. The various components are thoroughly mixed so as to form a uniform dispersion mixture of the coating composition's components, in particular, the fluorocarbon polymers in the epoxy resins.

A relatively uniform film of coating mixture is applied onto a substrate by any of the known means such as wire wound rod, Guardco® wet film applicator rods, knife, bar, airless spraying, dipping, roller coating, flowing, brushing, conventional and/or electrostatic spray gun, electrodeposition and the like. The various substrates employed can be wood, paper, metal, pretreated metal, plastic and the like. Generally, the coating composition is applied in an amount sufficient to provide a dry cured coating thickness of from 1 ml to 100 ml, preferably from 6 ml to 26 ml. Optionally, multiple coats of the composition may be applied to the substrate. By selection of components and additives the coating compositions may be applied both as translucent coatings or opaque coatings.

The coating mixture is then cured and solidified to form the coating composition. After cure, there is present on the surface of the substrate a hard, non-tacky, non-mar adhesive and chemically resistant coating which tenaciously adheres to the substrate.

The coating compositions of the present invention can be patched if the coating is damaged by applying a fresh coat of the coating mixture over the defective area and then curing the coating mixture to form the coating.

The coating compositions of the present invention are comprised of a uniform dispersion of a fluorocarbon polymer in a polymerized epoxy resin matrix. It is theorized that in curing the fine homogeneous dispersion of the coating composition mixture, the fluorine containing molecules becomes incorporated throughout the epoxy network matrix due to the polymerization of the epoxy resin to epoxy resin trapping and physically holding the fluorine containing molecules in the matrix. The coating compositions superior properties are derived from the novel multifunctional combination of epoxy and fluorocarbon moeities resulting in excellent adhesion, good chemical resistance and wetting properties of the epoxy resins being retained together with excellent chemical resistance, hydrophobicity and release properties of the fluorocarbon polymers.

## Specific Embodiments

The following examples demonstrate the process and advantages of the present invention.

The following compositions C and D were prepared by a ball milling method. The laboratory ball mill consists of a steel cylinder which has an end that can be removed by threaded bolts. The cylinder was charged with approximately equal volumes of about 0.95 cm (3/85") stainless steel balls and the composition. The cylinder was closed and the composition was dispersed by the rapid rotation of the cyclinder on rollers. The steel balls rolled, abraded and impinged upon the composition physically beating it to smaller particle sizes.

Composition C contained about 43 weight percent Shell Epon® 828 Liquid Epoxy Resin, about 10 weight percent cellosolve (available from Fischer Scientific, Cleveland, Ohio), about 2 weight percent FC-430-fluorosurfactant (available from 3M, St. Paul, Minnesota) and about 20 weight percent DuPont DLX-6000

polytetrafluoroethylene with an average particle size of about 150 µm. This composition was ball-milled rotated for about 8 hours. The composition dispersion formed was a smooth, fluid, pourable coating material.

Composition D contained about 43 weight percent Shell Epon® 828 Liquid Epoxy Resin, about 10 weight percent cellosolve, about 2 weight percent FC-430-Fluorosurfactant and about 20 weight percent DuPont 8A polytetrafluoroethylene with an average particle size of about 500 µm. The composition was ball-milled rotated for about 8 hours. The composition dispersion was very poor, had a grainy texture and had the consistency of oatmeal. The ball mill was then closed and rotated for about 16 more hours. There was no improvement in quality of the composition dispersion after the second ball milling. Then about 10 weight percent of cellosolve was added to reduce the viscosity of the composition. The ball mill was closed and rotated for about 8 hours. The composition dispersion was poor, very grainy and had the texture of oatmeal.

Composition C employing about 150 µm polytetrafluoroethylene produced a smooth usable well dispersed coating material with good rheological properties. Composition D employing about 500 µm polytetrafluoroethylene produced an unsuitable poorly dispersed coating material with poor rheological properties.

Coating composition E contained about 43 weight percent Shell Epon® 828 Liquid Epoxy Resin, about 10 weight percent cellosolve, about 2 weight percent FC-430 fluorosurfactant, about 20 weight percent Dupont DLX-6000 micropowder polytetrafluoroethylene and about 25 weight percent 2:1 anchamine TL/TLS blend (available from Pacific-Anchor Chemical Corp., Los Angeles, California).

Coating composition F contained about 43 weight percent Shell Epon® 828 Liquid Epoxy Resin, about 10 weight percent cellosolve, about 2 weight percent FC-430 fluorosurfactant, about 20 weight percent titanium dioxide and about 25 weight percent 2:1 anchamine TL/TLS blend.

Compositions E & F were prepared by charging the components into a steel ball mill except for the anchamine curing agent and were dispersed for about 4 hours. The cylinder was charged with approximately equal volumes of about 0.95 cm (3/8") stainless steel balls and the composition. Immediately prior to application of the coating on the substrate the curing agent is added to the composition. The coating compositions were then applied to the surface of cold rolled steel sandblasted to a 2 ml anchor particle, KTA-Tator panels (available from KTA-Tator Inc., Pittsburg, Pennsylvania).

The test panels were roller coated until the resulting thickness equaled about a 20 ml coating. The coated panels were cured for about 15 minutes at about 80°C between coats and followed by a postcure for about 4 hours at about 100°C.

The test panels were then attached horizontally to each end of a test cell, which consisted of a vertically oriented glass cylinder with a reflux condenser which can be capped at both ends by means of metal plates and about 10.2 cm (4 inches) outside diameter teflon washers. The cylinder was about three-quarters filled with 7M Hydrochloric Acid solution and then heat was applied by means of a heating tape or a heating girdle around the outside of the test cell. In this way, about a 7.6 cm (3 inch) circle of the bottom part of the coated test panel was immersed in refluxing test solution, while about a 7.6 cm (3 inch) circle of the top part of the coated test panel was exposed to a continuously condensing vapor phase of the test solution. The test panels were run in the test cell at reflux temperature of the 7M Azeotropic Hydrochloric Acid at about 108°C. Samples of the hydrochloric acid test solution were taken at regular intervals and analyzed for parts per million iron. The samples were analyzed by Inductively Coupled Plasma Analysis for iron concentration in parts per million. The results are shown in Table I.

The test results demonstrate that an epoxy fluorocarbon coating composition employing about 150 µm fluorocarbon polymer produces an improved smooth, well dispersed coating material with good rheological properties.

The results shown in Table I of the novel coatings composition of the instant invention demonstrates that the epoxy fluorocarbon coating is much more protective against corrosion resistance than a comparative epoxy titianium oxide coating in an acid environment.

Although the invention has been described in detail through the preceding examples, these examples are for the purpose of illustration only, and it is understood that variations and modifications can be made by one skilled in the art without departing from the spirit and the scope of the invention as hereinafter claimed.

Table I

| Concentration of Iron | | |
|---|---|---|
| Time (hrs.) | Composition E Epoxy/PTFE Coating Iron (mg/g) | Composition F Epoxy/$TiO_2$ Iron (mg/g) |
| 0 | 0 | <5 |
| 24 | 3 | <5 |
| 72 | 55 | 1100 |
| 144 | 340 | 2900 |
| 192 | 560 | 3800 |
| 238 | 820 | 5600 |
| 246 | 810 | 6200 |
| 384 | 3600 | - |

## Claims

**1.** A coating composition comprising 5 to 24 percent by weight of a powdered non-melt processable fluorocarbon polymer with a particle size of less than or equal to 150 µm, 95 to 70 percent by weight of a polymerized epoxy resin wherein the fluorocarbon polymer is dispersed in the epoxy resin, and up to or equal to 2% of a fluorosurfactant.

**2.** A coating composition as claimed in claim 1 characterised in that the composition is solvent free.

**3.** A coating composition as claimed in claim 1 or claim 2 characterised in that said composition comprises from 10 to 20 percent of powdered fluorocarbon polymer and from 90 to 75 percent of an epoxy resin.

**4.** A coating composition as claimed in any of claims 1 to 3 characterised in that said epoxy resin is selected from the group consisting of diglycidyl ether of bisphenol A, epoxidized novolak, cyclohexene oxide, epoxidized cycloalkene, glycidyl ester of acrylic acid, glycidyl alkyl ether, glycidyl aryl ether, ester of epoxidized cyclic alcohol, ester of epoxidized cycloalkanecarboxylic acid, halogenated epoxide, styrene oxide, bisphenol F epoxide and combinations thereof.

**5.** A coating composition as claimed in any of claims 1 to 4 characterised in that the epoxy resin is polymerized by a catalytic curing agent selected from benzildimethylamine, boron trifluoride monoethylamine, formic acid, benzoic acid, formic anhydride, acetic anhydride, oxalic acid, malonic acid, succinic acid, ortho-cresol, meta-cresol, para-cresol and combinations thereof to form a coating.

**6.** A coating composition as claimed in any of claims 1 to 5 characterised in that the epoxy resin is polymerized by a stoichiometric curing agent selected from polysulfide, polyamide, aliphatic amine, amidoamine, aromatic amine, anhydride, melamine-formaldehyde, urea-formaldehyde, phenol-formaldehyde and combinations thereof to form a coating.

**7.** A coating composition as claimed in any of claims 1 to 6 characterised in that the composition is cured by a photoinitiated curing agent selected from benzophenone, triaryl sulfonium salts, benzoin ether, substituted acetophenone, benzil and combinations thereof to form a coating.

**8.** A process for preparing an epoxy fluorocarbon coating comprising:
(a) forming a dispersion of powdered fluorocarbon polymer wherein said fluorocarbon is non-melt processable polymer with a particle size less than or equal to 150 µm in an epoxy resin,
(b) adding a fluorosurfactant to the dispersion in an amount up to or equal to 2%,
(c) adding a curing agent to the dispersion to form a mixture,
(d) applying the mixture to a substrate to form a coating, and
(e) curing the coating at 20°C to 150°C.

9. A process as claimed in claim 8 characterised in that the coating is cured at 80 °C to 140 °C.

10. A process as claimed in claim 8 or claim 9 characterised in that the fluorocarbon polymer is polytetrafluoroethylene.

11. A process for patching an epoxy fluorocarbon coating comprising:
    (a) forming a dispersion of powdered polytetrafluoroethylene polymer with a particle size less than or equal to 150 µm in an epoxy resin,
    (b) adding a fluorosurfactant to the dispersion in an amount up to or equal to 2%,
    (c) adding a curing agent to the dispersion to form a mixture,
    (d) applying the mixture to the area lacking the coating on a substrate, and
    (e) curing the coating at 20 °C to 150 °C.

12. A coated article of a composition comprising 5 to 24 percent by weight of a powdered polytetrafluoroethylene polymer with a particle size of less than or equal to 150 µm dispersed in 95 to 70 percent by weight of a polymerized epoxy resin and up to 2% fluorosurfactant.

13. A coating composition comprising 5 to 24 percent by weight of a powdered fluorocarbon polymer wherein said fluorocarbon is non-melt processable and wherein said fluorocarbon has a particle size of less than or equal to 150 µm dispersed in 95 to 70 percent by weight of a polymerized epoxy resin and up to 2% fluorosurfactant.

**Revendications**

1. Composition de revêtement comprenant 5 à 25 pour-cent en poids d'un polymère fluorocarboné en poudre pouvant être traité, sans fusion, ayant une taille de particules inférieure ou égale à 150 um, 95 à 70 pour- cent en masse d'une résine époxyde polymérisée, dans laquelle le polymère fluorocarboné est dispersé dans la résine époxyde, et jusqu'à au plus 2% d'un tensioactif fluoré.

2. Composition de revêtement telle que revendiquée dans la revendication 1, caractérisée en ce que la composition est exempte de solvant.

3. Composition de revêtement telle que revendiquée dans la revendication 1 ou la revendication 2, caractérisée en ce que ladite composition comprend de 10 à 20 pour-cent du polymère fluorocarboné, et de 90 à 75 pour-cent d'une résine époxyde.

4. Composition de revêtement telle que revendiquée dans l'une quelconque des revendications 1 à 3, caractérisée en ce que ladite résine époxyde est choisie parmi le groupe constitué de : éther de diglycidylique de bisphénol A, novolak époxydé, oxyde de cyclohexène, cycloalcène époxydé, ester glycidylique d'acide acrylique, éther d'alkyle et de glycidyle, éther d'aryle et de glycidyle, ester d'alcool cyclique époxydé, ester d'acide cycloalcanecarboxylique époxydé, époxyde halogéné, oxyde de styrène, époxyde de bisphénol F et ses combinaisons.

5. Composition de revêtement telle que revendiquée dans l'une quelconque des revendications 1 à 4, caractérisée en ce que la résine époxyde est polymérisée à l'aide d'un catalyseur de polymérisation choisi parmi : benzyldiméthylamine, trifluorure de bore-monoéthylamine, acide formique, acide benzoïque, anhydride formique, anhydride acétique, acide oxalique, acide malonique, acide succinique, ortho-crésol, méta-crésol, para-crésol et ses combinaisons pour former un revêtement.

6. Composition de revêtement telle que revendiquée dans l'une quelconque des revendications 1 à 5, caractérisée en ce que la résine époxyde est polymérisée par un agent stoechiométrique de polymérisation choisi parmi : polysulfite, polyamide, amine aliphatique, amidoamine, amine aromatique, anhydride, formaldéhyde de mélamine, formaldéhyde d'urée, formaldéhyde de phénol et ses combinaisons pour former un revêtement.

7. Composition de revêtement telle que revendiquée dans l'une quelconque des revendications 1 à 6, caractérisée en ce que la composition est polymérisée par un initiateur photochimique choisi parmi : benzophénone, sels de sulfonium triaryle, éther de benzoïne, acétophénone substituée, benzyle et ses combinaisons pour former un revêtement.

8. Procédé de préparation d'un revêtement à base d'une résine époxyde et d'un polymère fluorocarboné consistant à :
(a) former une dispersion d'un polymère fluorocarboné pulvérisé dans laquelle ledit polymère fluorocarboné est un polymère à traiter sans fusion, avec une taille de particule inférieure ou égale à 150 µm dans une résine époxyde,
(b) ajouter un tensioactif fluoré à la dispersion dans une quantité inférieure ou égale à 2%,
(c) ajouter un agent de polymérisation à la dispersion pour former un mélange,
(d) appliquer le mélange à un matériau pour former un revêtement, et
(e) polymériser le revêtement à une température comprise entre 20° C et 150° C.

9. Procédé tel que revendiqué dans la revendication 8, caractérisé en ce que le revêtement est polymérisé entre 80° C et 140° C.

10. Procédé tel que revendiqué dans la revendication 8 ou 9, caractérisé en ce que le polymère fluorocarboné est du polytétrafluoroéthylène.

11. Procédé de réparation d'un revêtement à base d'une résine époxyde et d'un polymère fluorocarboné consistant à :
(a) former une dispersion de polymère de polytétrafluoroéthylène en poudre avec une taille de particules inférieure ou égale à 150 µm dans une résine époxyde,
(b) ajouter un tensioactif fluoré à la dispersion dans une quantité inférieure ou égale à 2%,
(c) ajouter un agent de polymérisation à la dispersion pour former un mélange,
(d) appliquer le mélange à la zone dépourvue de revêtement sur un matériau, et
(e) polymériser le revêtement entre 20° C et 150° C.

12. Produit enduit d'une composition comprenant de 5 à 24% en poids d'un polymère de polytétrafluoroéthylène pulvérisé, avec une taille de particules inférieure ou égale à 150 µm, dispersé dans 95 à 70 pour-cent en poids d'une résine époxyde polymérisée et jusqu'à 2% de tensioactif fluoré.

13. Composition de revêtement comprenant de 5 à 24 pour-cent en poidsd'un polymère fluorocarboné en poudre, où ledit polymère fluorocarboné peut être traité sans fusion et où ledit polymère fluorocarboné a une taille de particules inférieure ou égale à 150 µm, dispersé dans 95 à 70 pour-cent en poidsd'une résine époxyde polymérisée et jusqu'à de 2% de tensioactif fluoré.

## Patentansprüche

1. Überzugsmittelzusammensetzung, umfassend 5 bis 24 Gewichtsprozent eines pulverisierten, nichtschmelzverarbeitbaren Fluorkohlenstoffpolymeren mit einer Teilchengröße von weniger als oder gleich 150 µm, 95 bis 70 Gewichtsprozent eines polymerisierten Epoxyharzes, wobei das Fluorkohlenstoffpolymere in dem Epoxyharz dispergiert ist, und bis zu oder gleich 2 % eines Fluorosurfactants.

2. Überzugsmittelzusammensetzung nach Anspruch 1, dadurch gekennzeichnet, daß die Zusammensetzung lösungsmittelfrei ist.

3. Überzugsmittelzusammensetzung nach Anspruch 1 oder 2, dadurch gekennzeichnet, daß die Zusammensetzung 10 bis 20 Prozent pulverisiertes Fluorkohlenstoffpolymeres und 90 bis 75 Prozent eines Epoxyharzes enthält.

4. Überzugsmittelzusammensetzung nach einem der Ansprüche 1 bis 3, dadurch gekennzeichnet, daß das Epoxyharz ausgewählt ist aus der Gruppe von Diglycidylether von Bisphenol A, epoxidiertem Novolak, Cyclohexenoxid, epoxidiertem Cycloalken, Glycidylester von Acrylsäure, Glycidylalkylether, Glycidylarylether, Ester von epoxidiertem cyclischem Alkohol, Ester von epoxidierter Cycloalkancarbonsäure, halogeniertem Epoxid, Styroloxid, Bisphenol F-epoxid und Kombinationen davon.

**5.** Überzugsmittelzusammensetzung nach einem der Ansprüche 1 bis 4, dadurch gekennzeichnet, daß das Epoxyharz polymerisiert ist durch ein katalytisches Härtungsmittel, ausgewählt aus Benzildimethylamin, Bortrifluorid-monoethylamin, Ameisensäure, Benzoesäure, Ameisensäureanhydrid, Essigsäureanhydrid, Oxalsäure, Malonsäure, Bernsteinsäure, ortho-Cresol, meta-Cresol, para-Cresol und Kombinationen davon, um einen Überzug zu bilden.

**6.** Überzugsmittelzusammensetzung nach einem der Ansprüche 1 bis 5, dadurch gekennzeichnet, daß das Epoxyharz polymerisiert ist durch ein stöchiometrisches Härtungsmittel, ausgewählt aus Polysulfid, Polyamid, aliphatischem Amin, Amidoamin, aromatischem Amin, Anhydrid, Melamin-Formaldehyd, Harnstoff-Formaldehyd, Phenol-Formaldehyd und Kombinationen davon, um einen Überzug zu bilden.

**7.** Überzugsmittelzusammensetzung nach einem der Ansprüche 1 bis 6, dadurch gekennzeichnet, daß die Zusammensetzung gehärtet ist durch ein fotoinitiiertes Härtungsmittel, ausgewählt aus Benzophenon, Triarylsulfoniumsalzen, Benzoinether, substituiertem Acetophenon, Benzil und Kombinationen davon, um einen Überzug zu bilden.

**8.** Verfahren zur Herstellung eines Epoxy-Fluorkohlenstoff-Überzugs, umfassend:
a) die Bildung einer Dispersion von pulverisiertem Fluorkohlenstoffpolymerem, worin der Fluorkohlenstoff nichtschmelzverarbeitbares Polymer mit einer Teilchengroße von weniger als oder gleich 150 $\mu$m ist, in einem Epoxyharz,
b) Zusatz eines Fluorosurfactants zu der Dispersion in einer Menge bis zu oder gleich 2 %,
c) Zusatz eines Härtungsmittels zu der Dispersion unter Bildung eines Gemischs,
d) Auftrag des Gemischs auf ein Substrat unter Bildung eines Überzugs, und
e) Härtung des Überzugs bei 20 ° C bis 150 ° C.

**9.** Verfahren nach Anspruch 8, dadurch gekennzeichnet, daß der Überzug bei 80 ° C bis 140 ° C gehärtet wird.

**10.** Verfahren nach Anspruch 8 oder Anspruch 9, dadurch gekennzeichnet, daß das Fluorkohlenstoffpolymere Polytetrafluorethylen ist.

**11.** Verfahren zum Flicken eines Epoxy-Fluorkohlenstoffüberzugs, umfassend:
a) die Bildung einer Dispersion von pulverisiertem Polytetrafluorethylenpolymerem mit einer Teilchengröße von weniger als oder gleich 150 $\mu$m in einem Epoxyharz,
b) Zusatz eines Fluorosufactants zu der Dispersion in einer Menge bis zu oder gleich 2 %,
c) Zusatz eines Härtungsmittels zu der Dispersion zur Bildung eines Gemischs,
d) Auftrag des Gemischs auf die Fläche eines Substrats, auf der der Überzug fehlt, und
e) Härten des Überzugs bis 20 ° C bis 150 ° C.

**12.** Gegenstand, beschichtet mit einer Zusammensetzung, umfassend 5 bis 24 Gewichtsprozent eines pulverisierten Polytetrafluorethylenpolymeren mit einer Teilchengröße vor weniger als oder gleich 150 $\mu$m, dispergiert in 95 bis 70 Gewichtsprozent eines polymerisierten Epoxyharzes und bis zu 2 % Fluorosurfactant.

**13.** Überzugsmittelzusammensetzung, umfassend 5 bis 24 Gewichtsprozent eines pulverisierten Fluorkohlenstoffpolymeren, worin der Fluorkohlenstoff nicht-schmelzverarbeitbar ist, und worin der Fluorkohlenstoff eine Teilchengröße von weniger als oder gleich 150 $\mu$m aufweist, dispergiert in 95 bis 70 Gewichtsprozent eines polymerisierten Epoxyharzes und bis zu 2 % Fluorosufactant.